# EUROPEAN PATENT SPECIFICATION

(11) **EP 4 242 732 B1**
(45) Date of publication and mention of the grant of the patent: **16.09.2026**
(21) Application number: 21889302.2
(22) Date of filing: 09.11.2021
(51) Int. Cl.: G02C 7/00, G02C 7/02, G02B 1/18, C23C 14/06, C23C 14/24, C23C 14/20, C23C 14/10, C23C 14/30, C23C 14/08, G02B 1/115

(54) **SPECTACLE LENS AND SPECTACLES**
BRILLENGLAS UND BRILLE
VERRE DE LUNETTES ET LUNETTES

(30) Priority: 09.11.2020 JP 2020186825; 19.05.2021 JP 2021084591
(43) Date of publication of application: 13.09.2023
(73) Proprietor: HOYA LENS THAILAND LTD., Pathumthani 12130 (TH)
(72) Inventor: NOMURA Takumi, Tokyo 160-8347 (JP); UEDA Kyosuke, Tokyo 160-8347 (JP)
(74) Representative: Hoffmann Eitle
(86) International application number: PCT/JP2021/041073
(87) International publication number: WO 2022/097751

(56) References cited:
- EP-B1- 0 903 389
- JP-A- 2006 184 849
- JP-A- 2006 184 849
- JP-A- 2011 127 137
- JP-A- 2016 065 269
- JP-A- 2018 159 860
- JP-A- 2018 159 860
- JP-A- 2020 106 751
- JP-A- 2020 142 494
- JP-A- 2020 142 494
- JP-A- H1 048 578
- US-A1- 2007 166 522
- US-A1- 2017 227 681

## Description

### Technical Field

The present invention relates to a spectacle lens and spectacles.

### Background Art

Spectacle lenses are each generally structured to have one or more functional layers on a surface of a lens substrate (see, for example, Patent Literature 1). US2007/166522A1 is cited as an example of spectacle lens of the prior art with a metal containing layer.

### Citation List

### Patent Literature

Patent Literature 1: JP H09-327622 A

### Summary of Invention

### Technical Problem

In recent years, there is an increasing need for antibacterial functions. Under such circumstances, if it is possible to impart a function (that is, antimicrobial performance) capable of suppressing the growth of bacteria to the spectacle lens, the added value of the spectacle lens can be increased.

An object of one aspect of the present invention is to provide a spectacle lens having antimicrobial performance. Solution to Problem

One aspect of the present invention relates to a spectacle lens comprising, in this order:
(1) a lens substrate,
(2) an inorganic layer,
(3) a metal-containing layer wherein
   - a metal contained in the metal-containing layer is silver and platinum,
   - the metal is contained in the form or a single metal or a metal alloy, and
   - the layer has a film thickness of 1-3 nm, and
(4) a water-repellent layer which is directly layered on the metal-containing layer.

The metal-containing layer can function as an antimicrobial layer for imparting antimicrobial performance to the spectacle lens. By having such a layer, the spectacle lens can exhibit antimicrobial performance. Advantageous Effects of Invention

According to an aspect of the present invention, it is possible to provide a spectacle lens having antimicrobial performance and spectacles including the spectacle lens. Brief Description of Drawing

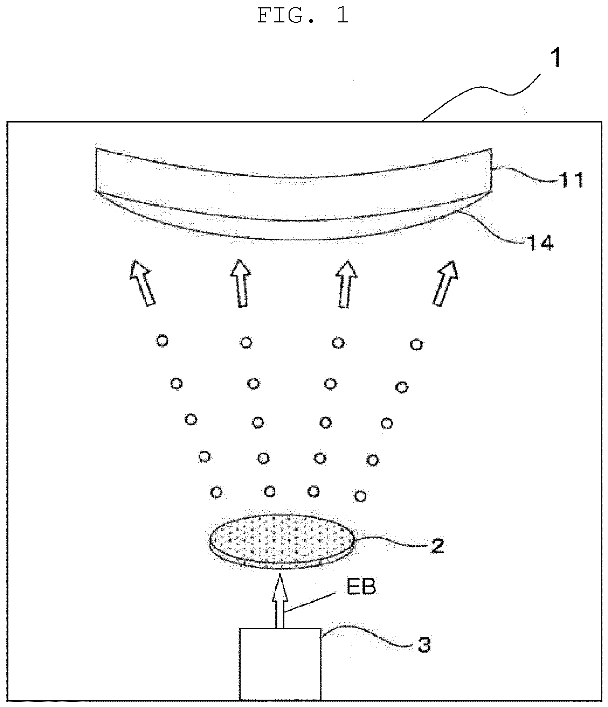

Fig. 1 is a schematic view illustrating an example of a vacuum vapor deposition apparatus including an electron gun.

### Description of Embodiments

### [Spectacle lens]

Hereinafter, the above-described spectacle lens will be described in more detail.

### <Metal-containing layer>

The spectacle lens includes a metal-containing layer between an inorganic layer and a water-repellent layer, and the metal contained in the metal-containing layer is silver and platinum.

The metal-containing layer contains silver (Ag) as a first metal and contains one or more metals other than silver as a second metal. The second metal is platinum (Pt).

The form of the metal in the metal-containing layer include a form of a single metal or a metal alloy. In the metal-containing layer, silver may exist in a plurality of forms. The same point applies to the second metal. The inventors of the present invention estimate that at least part of the silver as the first metal can be ionized by oxidation to exert antimicrobial performance, and this contributes to the fact that the metal-containing layer can function as an antimicrobial layer. In addition, the present inventors estimate that the sustainability of antimicrobial performance can be increased by selecting, as the second metal, the above-described metal having the effect of controlling the progress of oxidation of silver. However, the present invention is not limited to the estimation described herein.

In one embodiment, the metal-containing layer may be a metal-containing inorganic layer. In the present invention and the present specification, the "inorganic layer" is a layer containing an inorganic substance, and is preferably a layer containing an inorganic substance as a principal component. Here, the principal component occupies the largest part in a layer and usually occupies approximately 50 to 100 mass% or even approximately 90 to 100 mass% based on the mass of the layer. The same applies to the principal components described below. The metal-containing inorganic layer may contain the first metal and the second metal in the form of an inorganic substance such as a single metal, an alloy. In this respect, the inorganic substance is preferable as a component constituting a layer provided in a spectacle lens for which treatment involving heating is often performed during a producing process, because the inorganic substance has high thermal stability and tends to be hardly thermally decomposed.

The metal-containing layer is a layer located between the inorganic layer and the water-repellent layer, and can be formed on the inorganic layer by a deposition method selected from the group consisting of a dry film formation method and a wet film formation method. Examples of the dry film formation method include physical vapor deposition and chemical vapor deposition, and examples of the wet film formation method include a coating method and the like. From the viewpoint of ease of forming a metal-containing layer of a thin film excellent in film thickness uniformity, as a film formation method of the metal-containing layer, a dry film formation method is preferable, and a physical vapor deposition method is more preferable. Examples of the physical vapor deposition method include a vapor deposition method, a sputtering method, and the like. The vapor deposition method is preferable, and an electron-beam (EB) vapor deposition method is more preferable from the viewpoint of ease of forming a metal-containing layer of a thin film excellent in film thickness uniformity.

The electron-beam vapor deposition method is a film formation method in which a vapor deposition source is irradiated with an electron-beam from an electron gun in vacuum, a vapor deposition material included in the vapor deposition source is heated and vaporized, and the vapor deposition material is deposited on a deposition target to form a vapor-deposited film. On the other hand, examples of the vapor deposition method also include a method of heating a vapor deposition material by heating the internal atmosphere of a vapor deposition apparatus by using a heating unit (a heater, etc.) disposed in the apparatus to vaporize the vapor deposition material (hereinafter, referred to as a "heating vapor deposition method"). In the heating vapor deposition method, a deposition target disposed in the vapor deposition apparatus is also heated. Meanwhile, a lens substrate of spectacle lens is preferably a plastic lens substrate as described later, but the plastic lens substrate may be deformed when exposed to a high temperature. Thus, when performing film formation on a plastic lens substrate by adopting a heating vapor deposition method, it is preferable to set the heating temperature in consideration of suppressing deformation of the plastic lens substrate. On the other hand, since the heating temperature thus set is not necessarily a heating temperature suitable for the vapor deposition material, it may not be easy to form a thin vapor-deposited film having excellent film thickness uniformity. Alternatively, a vapor deposition material that can be vaporized at a set heating temperature should be selected. As a result, the type of usable vapor deposition material may be limited. In contrast, in the electron-beam vapor deposition method, since the vapor deposition material is heated by irradiating the vapor deposition source with the electron-beam, the vapor-deposited film can be formed without exposing the deposition target to a high temperature as in the above-described heating vapor deposition method. From the above viewpoint, the electron-beam vapor deposition method is particularly preferable as the film formation method of the metal-containing layer. Hereinafter, specific embodiments of a film formation method of the metal-containing layer by an electron-beam vapor deposition method will be described. However, the present invention is not limited to the following embodiments.

As the vapor deposition source, a vapor deposition source containing the first metal and the second metal can be used. Such a vapor deposition source may be prepared, for example, by the following procedure.

A solution containing particles of silver (silver particles) as the first metal (hereinafter, also referred to as a "first metal-containing solution") is prepared. Such a solution can be, for example, an aqueous solution, and can be an aqueous dispersion of silver particles. The concentration of the silver particles in the first metal-containing solution may be, for example, in the range of 1000 to 10000 ppm. In the present invention and the present specification, ppm is on a mass basis.

In addition to the above solution, a solution containing particles of one or more kinds of the second metal (hereinafter, also referred to as a "second metal-containing solution") is prepared. Such a solution can be, for example, an aqueous solution, and can be an aqueous dispersion of second metal particles. As the second metal-containing solution, only one solution containing one or more kinds of particles of the second metal can be used, or two or more solutions containing one or more kinds of particles of the second metal can be used. In either case, the concentration of the second metal particles in the second metal-containing solution may be, for example, in the range of 1000 to 10000 ppm. Here, in a case where the second metal-containing solution contains two or more kinds of particles of the second metal, the above concentration refers to the concentration for the sum of the two or more kinds of metal particles.

As each of the above solutions, for example, a commercially available product as an aqueous dispersion of metal particles may be used as it is, or a commercially available product may be diluted and then used.

After the solution is thus prepared, a carrier is impregnated with the solution. The plurality of kinds of solutions may be impregnated into the carrier separately, or may be impregnated simultaneously, or the carrier may be impregnated with a mixed solution obtained by mixing the plurality of kinds of solutions. The volume of the first metal-containing solution to be impregnated into the carrier may be, for example, in the range of 0.1 to 5.0 ml. The volume of the second metal-containing solution to be impregnated into the carrier may be, for example, in the range of 0.1 to 5.0 ml. In addition, the volume of the second metal-containing solution may be 0.1 to 5 times the volume of the first metal-containing solution. Here, in a case where two or more kinds of solutions are used as the second metal-containing solution, the liquid amount refers to the liquid amount with respect to the total of the two or more kinds of solutions.

Examples of the method of impregnating a carrier with a solution include a method of injecting or spraying a solution into a carrier, a method of soaking a carrier in a solution, or the like.

Meanwhile, the carrier may be, for example, a porous body, and may be made of, for example, a metal, an alloy, or a ceramic. Specific examples of the porous body include a sintered filter. The sintered filter may be a sintered body obtained by sintering a powder material such as metal powder, alloy powder, ceramic powder, or the like.

Drying treatment using a known procedure after impregnating a carrier with the above-described solution may be conducted to produce a carrier carrying the first metal particles and the second metal particles.

The particle size of each metal particle described above is preferably 1 nm or larger and 10 nm or less, and more preferably 1 nm or larger and 5 nm or less from the viewpoint of easy vaporization by electron beam irradiation.

The electron-beam vapor deposition may be performed in a vacuum vapor deposition apparatus including an electron gun. Fig. 1 illustrates a schematic view of an example of the vacuum vapor deposition apparatus.

In a vacuum vapor deposition apparatus 1 illustrated in Fig. 1 (commonly called a "vacuum chamber"), a deposition target 11 faces, via a vapor deposition source 2, an electron gun 3. The surface of the deposition target 11 on the vapor deposition source side is a surface of the inorganic layer on which a metal-containing layer 14 is to be deposited. The electron beam can be generated by applying a heating current to a filament provided in the electron gun 3. The heating current may be set according to, for example, the configuration of the electron gun used, the type of the vapor deposition material, and the like. Further, irradiation conditions such as electron beam irradiation time may be set according to, for example, a desired film thickness or the like. When the vapor deposition source 2 is irradiated with an electron beam EB emitted from the electron gun, the vapor deposition material included in the vapor deposition source is heated and vaporized. As a result, the vapor deposition material is deposited on a surface of the deposition target 11 to deposit the metal-containing layer 14. In a case where a vapor deposition source in which particles of the first metal and particles of the second metal are supported on a carrier as described above is used as the vapor deposition source, the metal-containing layer 14 can be deposited as a vapor-deposited film containing these metals on the deposition target 11 by heating and vaporizing the particles of the first metal and the particles of the second metal, which are vapor deposition materials, by electron-beam irradiation. The inside of the vacuum chamber is, for example, an air atmosphere. The internal pressure may be usually a pressure at which vacuum vapor deposition is performed, and may be, for example, 2 × 10⁻² Pa or less. The number of times of performing the electron-beam vapor deposition process is one or more, and the electron-beam vapor deposition process may be performed twice or more using the same kind or different kinds of vapor deposition sources. For example, the electron-beam vapor deposition process may be performed twice or more using the same kind or different kinds of vapor deposition sources to form a metal-containing layer having a larger film thickness.

Meanwhile, JP H09-327622 A (Patent Literature 1) described above states that the thickness of the surface cured film formed by curing an antimicrobial coating is preferably 0.5 µm or more (see paragraph 0019 of the same publication). However, since such a thick film layer can greatly affect the reflection characteristics and/or transmission characteristics of the spectacle lens, it is inferred that in a case where such a layer is provided in the spectacle lens for imparting antimicrobial performance, the optical design of existing products usually has to be greatly changed. In contrast, from the viewpoint of imparting an antimicrobial performance to a spectacle lens by including a layer that can function as an antimicrobial layer in the spectacle lens without changing or greatly changing the optical design of existing products, it is preferable that the film thickness of the metal-containing layer is thin in order to reduce the influence of the presence of the metal-containing layer on the reflection characteristics and/or transmission characteristics of the spectacle lens. From this point of view, the film thickness of the metal-containing layer is 1 nm or more and 3 nm or less.

In the present invention and the present specification, the film thickness of the metal-containing layer is a physical film thickness. The same point applies to various thicknesses in the present invention and the present specification. The film thickness of the metal-containing layer refers to the total thickness of two or more layers for a spectacle lens in which the two or more layers of the same type or different types of metal-containing layers are layered by two or more film formation processes. The electron-beam vapor deposition method described above is a preferable film formation method in forming a vapor-deposited film having a thin film thickness in the above range and excellent film thickness uniformity. The film thickness of each layer included in a spectacle lens, such as the metal-containing layer, and the thickness of a lens substrate may be determined by, for example, observing a cross-section while using a scanning electron microscope (SEM) or the like.

Next, a lens substrate and various layers included in the spectacle lens will be described.

### <Lens substrate>

The lens substrate for the spectacle lens may be a plastic lens substrate or a glass lens substrate. The glass lens substrate may be, for example, a lens substrate made of inorganic glass. As the lens substrate, a plastic lens substrate is preferable from the viewpoint of being light, hardly broken, and easy to handle. Examples of the plastic lens substrate include a styrene resin including a (meth)acrylic resin, a polycarbonate resin, an allyl resin, an allyl carbonate resin such as diethyleneglycol bis(allylcarbonate) resin (CR-39), a vinyl resin, a polyester resin, a polyether resin, a urethane resin obtained through reaction between an isocyanate compound and a hydroxy compound such as diethylene glycol, a thiourethane resin obtained through reaction between an isocyanate compound and a polythiol compound, and a cured product (generally referred to as a transparent resin) obtained by curing a curable composition containing a (thio)epoxy compound having one or more intermolecular disulfide bonds. The lens substrate may be undyed (a colorless lens) or dyed (a dyed lens). The refractive index of the lens substrate can be, for example, approximately 1.60 to 1.75. However, the refractive index of the lens substrate is not limited to the above range, and may be within the above range, or over or under the above range. In the present invention and the present specification, the refractive index refers to a refractive index with respect to light having a wavelength of 500 nm. In addition, the lens substrate may be a lens having power (so-called prescription lens) or a lens having no power (so-called plain glass lens).

The spectacle lens can be various lenses such as a monofocal lens, a multifocal lens, and a progressive addition lens. The type of the lens is determined depending on the shapes of both surfaces of the lens substrate. Further, the surface of the lens substrate may be a convex surface, a concave surface, or a flat surface. In a common lens substrate and spectacle lens, the object-side surface is a convex surface, and the eyeball-side surface is a concave surface. However, the present invention is not limited to the above.

### <Inorganic layer>

The spectacle lens has an inorganic layer on a lens substrate. In the present invention and the present specification, the "inorganic layer" is a layer containing an inorganic substance, and preferably a layer containing an inorganic substance as a principal component as described above. The principal component is as described previously. The inorganic layer can be a layer directly layered on the surface of the lens substrate, or can be a layer indirectly layered on the surface of the lens substrate via one or more other layers. Examples of the other layer include one or more known layers such as what is generally called a hard coat layer, namely a cured layer made of a curable composition or a primer layer provided for improving adhesion. The type and film thickness of each layer above are not particularly limited, and may be determined according to the function and optical characteristics desired for a spectacle lens.

In one embodiment, the inorganic layer may be a multilayer film containing two or more inorganic layers. When the inorganic layer is a multilayer film, the metal-containing layer is provided on the uppermost inorganic layer of the multilayer film (i.e., the inorganic layer at the position farthest from the lens substrate). Examples of such a multilayer film include a multilayer film including one or more high refractive index layers and one or more low refractive index layers. Such a multilayer film may be an antireflection film having a property of preventing reflection of light with a specific wavelength or light in a specific wavelength range, or a reflection film having a property of reflecting light with a specific wavelength or light in a specific wavelength range. In the present invention and the present specification, "high" and "low" regarding "high refractive index" and "low refractive index" are relative notations. That is, the high refractive index layer refers to a layer having a refractive index higher than that of the low refractive index layer included in the same multilayer film. In other words, the low refractive index layer refers to a layer having a refractive index lower than that of the high refractive index layer included in the same multilayer film. The refractive index of the high refractive index material constituting the high refractive index layer can be, for example, 1.60 or more (for example, in a range of 1.60 to 2.40), and the refractive index of the low refractive index material constituting the low refractive index layer can be, for example, 1.59 or less (for example, in a range of 1.37 to 1.59). However, as described above, since the notations "high" and "low" relating to the high refractive index and the low refractive index are relative, the refractive indexes of the high refractive index material and the low refractive index material are not limited to the above ranges.

Specifically, a high refractive index material for forming the high refractive index layer can be a mixture of one or more oxides selected from the group consisting of zirconium oxide (for example, ZrO₂), tantalum oxide (Ta₂O₅), titanium oxide (for example, TiO₂), aluminum oxide (Al₂O₃), yttrium oxide (for example, Y₂O₃), hafnium oxide (for example, HfO₂), and niobium oxide (for example, Nb₂O₅). Meanwhile, examples of a low refractive index material for forming the low refractive index layer include one type of oxide or fluoride selected from the group consisting of silicon oxide (for example, SiO₂), magnesium fluoride (for example, MgF₂), and barium fluoride (for example, BaF₂), and a mixture of two or more types of oxides and fluorides selected therefrom. In the above examples, oxide and fluoride are expressed in a stoichiometric composition for convenience, but oxide or fluoride in which oxygen or fluorine is deficient or excessive as compared to the stoichiometric composition can also be used as the high refractive index material or the low refractive index material.

Preferably, the high refractive index layer is a film containing a high refractive index material as a principal component, and the low refractive index layer is a film containing a low refractive index material as a principal component. Such a film (for example, a vapor-deposited film) can be formed by performing film formation using a film formation material (for example, a vapor deposition material) containing the high refractive index material or the low refractive index material as a principal component. The film and the film formation material may include impurities, which are inevitably mixed, and may include another component, for example, another inorganic substance or a known additive component that supports film formation as long as the component does not impair the function of the principal component. The film formation can be performed by a known film formation method, and is preferably performed by vapor deposition, and more preferably performed by vacuum vapor deposition, from a viewpoint of ease of the film formation. The antireflection film may be, for example, a multilayer film in which a total of 3 to 10 layers of high refractive index layers and low refractive index layers are alternately layered. The film thickness of each high refractive index layer and the film thickness of each low refractive index layer may be determined according to the layer structure. Specifically, the combination of layers included in the multilayer film and the film thickness of each layer may be determined by an optical design simulation using a known technique on the basis of the refractive index of the film formation material for forming the high refractive index layer and the low refractive index layer, and desired reflection characteristics and transmission characteristics to be imparted to the spectacle lens by providing the multilayer film. In addition, the multilayer film may include, at a given position(s), one or more layers containing a conductive oxide as a principal component (conductive oxide layer), preferably one or more conductive oxide-containing vapor-deposited films formed by vapor deposition using a vapor deposition material containing a conductive oxide as a principal component.

In the spectacle lens, the metal-containing layer is provided on a surface of the inorganic layer. The metal-containing layer can be a layer directly layered on the surface of the inorganic layer, or can be a layer indirectly layered on the surface of the inorganic layer via one or more other layers. The other layers may refer to the above description.

### <Water-repellent layer>

In the spectacle lens, the water-repellent layer is provided on a surface of the metal-containing layer. In the present invention and the present specification, the "water-repellent layer" refers to a layer that contributes to the surface of the spectacle lens exhibiting water repellency, or contributes to exhibiting more favorable water repellency as compared to a case where this layer is not provided. The water-repellent layer is a layer directly layered on the surface of the metal-containing layer.

The water-repellent layer may be layered on the metal-containing layer by performing film formation process using a film formation material that can function as a water-repellent agent. Examples of the film formation method include a film formation method selected from the group consisting of a dry film formation method and a wet film formation method. For specific examples of the dry film formation method and the wet film formation method, the above description can be referred to.

In one embodiment, the water-repellent layer may be a fluorine-based organic layer. Here, the term "based" is used to mean "containing". In addition, in the present invention and the present specification, the "organic layer" is a layer containing an organic substance, and preferably a layer containing an organic substance as a principal component. The principal component is as described previously.

The fluorine-based organic layer may be layered on the metal-containing layer by performing a film formation process using a fluorine-based organic substance as a film formation material. Examples of a preferable film formation method for forming the fluorine-based organic layer include a dry film formation method, and a vapor deposition method is more preferable. Since the fluorine-based organic substance tends to have a lower boiling point than the vapor deposition material that can be used for forming the metal-containing layer described above, the use of a heating vapor deposition method is also preferable. The vapor deposition source in which the fluorine-based organic substance is supported on the carrier can be produced by impregnating the carrier with the solution containing the fluorine-based organic substance and then subjecting the carrier to a drying treatment. Regarding how to prepare the vapor deposition source, one can consult, if appropriate, the above description for the formation of the metal-containing layer.

Examples of the fluorine-based organic substance include m-xylene hexafluoride (C₆H₄(CF₃)₂) or the like.

In addition, examples of the fluorine-based organic substance also include the fluorine-based organosilane compound represented by the following general formula (1).

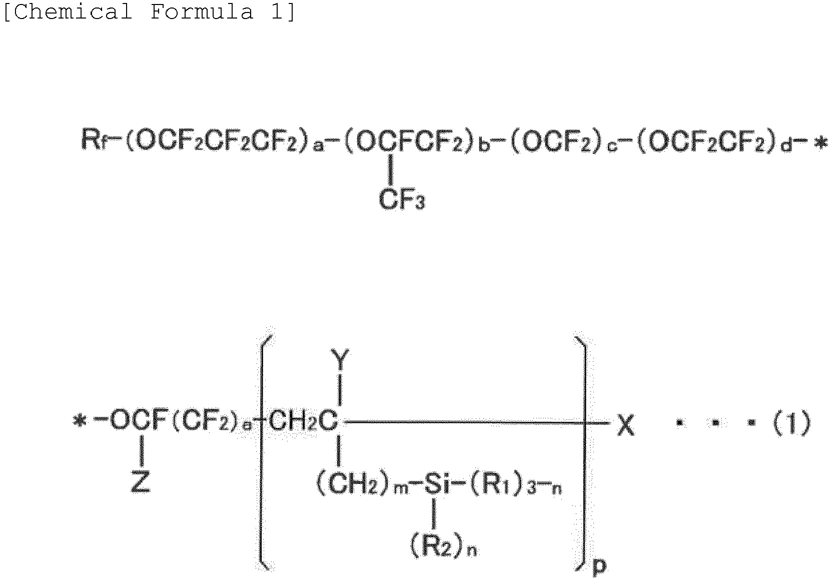

In the general formula (1), Rf is a C₁₋₁₆ linear or branched perfluoroalkyl group, and is preferably CF₃-, C₂F₅-, or C₃F₇-. R₁ is a hydrolyzable group, and is preferably, for example, a halogen atom, -OR₃, -OCOR₃, - OC(R₃)=C(R₄)₂, -ON=C(R₃)₂, or -ON=CR₅. More preferred is a chlorine atom, -OCH₃, or -OC₂H₅. Here, R₃ is an aliphatic hydrocarbon group or an aromatic hydrocarbon group, R₄ is a hydrogen atom or an aliphatic hydrocarbon group (for example, a lower aliphatic hydrocarbon group), and R₅ is a divalent aliphatic hydrocarbon group having 3 to 6 carbon atoms. R₂ is a hydrogen atom or a monovalent organic group. The monovalent organic group is preferably an inert group. The monovalent organic group is more preferably a C₁₋₄ monovalent hydrocarbon group. X is an iodine atom or a hydrogen atom, and Y is a hydrogen atom or an alkyl group (e.g., a lower alkyl group). Z is a fluorine atom or a trifluoromethyl group. Here, a, b, c, and d are each independently an integer in the range of 0 to 200 and preferably an integer in the range of 1 to 50. e is 0 or 1. m and n are each independently an integer in the range of 0 to 2 and preferably 0. p is an integer of 1 or more and preferably an integer in the range of 1 to 10.

In addition, the molecular weight (weight average molecular weight Mw) of the fluorine-based organosilane compound represented by the general formula (1) is not particularly limited, and may be, for example, in the range of 5 × 10² to 1 × 10⁵ or in the range of 5 × 10² to 1 × 10⁴.

In addition, the fluorine-based organosilane compound represented by the general formula (1) may be a fluorine-based organosilane compound represented by the following general formula (2).

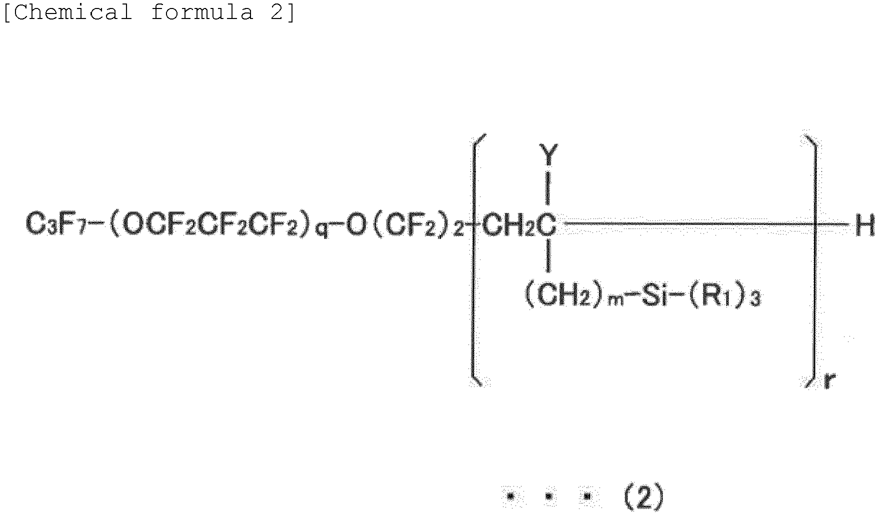

R₁, Y, and m in the general formula (2) have the same meaning as in the general formula (1). Here, q is an integer in the range of 1 to 50 and r is an integer in the range of 1 to 10.

The film thickness of the water-repellent layer may be, for example, 30 nm or less, 25 nm or less, 20 nm or less, or 15 nm or less. In addition, the film thickness of the water-repellent layer may be, for example, 5 nm or more or 10 nm or more. Further, the contact angle of the surface of the water-repellent layer with respect to water may be, for example, 100 degrees or more and 120 degrees or less. The water-repellent layer can be positioned as an outermost layer on one or both sides of the spectacle lens, for example.

The stack including at least the inorganic layer, the metal-containing layer, and the water-repellent layer may be formed on at least one surface of a lens substrate, and may also be formed on both surfaces. For example, the stack may be located on the object side of the spectacle lens, the stack may be located on the eyeball side of the spectacle lens, and the stacks may be located on the object side and the eyeball side of the spectacle lens. In a case where the stacks are located on both sides of the spectacle lens, the stack on the object side and the stack on the eyeball side may be the same stack or different stacks.

In the spectacle lens, the metal-containing layer can function as an antimicrobial layer, thereby eliciting antimicrobial performance. In addition, the spectacle lens has a water-repellent layer, and thus can also exert waterrepellency, whereby, for example, water burn of the lens or the like can be prevented. The inorganic layer functions as, for example, an antireflection film and thus can impart, to the spectacle lens, antireflection performance in response to light with a specific wavelength or light in a specific wavelength range.

### [Spectacles]

An aspect of the present invention relates to spectacles including the spectacle lens. Details of the spectacle lens included in the spectacles are as described above. A known technique can be applied to the configuration of a frame or the like of the above spectacles.

### Examples

Hereinafter, the present invention will be further described based on Examples. However, the present invention is not limited to embodiments illustrated in the Examples.

Hereinafter, the SiO₂ layer is a vapor-deposited film deposited using silicon oxide as a vapor deposition material, and the ZrO₂ layer is a vapor-deposited film formed using zirconium oxide as a vapor deposition material. Each vapor deposition material is a vapor deposition material consisting of the oxide described except for inevitably mixed impurities.

### [Example 1]

### <Production of hard coat layer-attached lens substrate>

A hard coat liquid containing inorganic oxide particles and a silicon compound was applied by spin coating to the entire surface on the object side (convex surface) of a plastic lens substrate produced from a monomer for a spectacle lens ("MR8" manufactured by Mitsui Chemicals, Inc.), and was heated and cured for 60 minutes in a heating furnace at a furnace inside temperature of 100°C to form a hard coat monolayer with a film thickness of 3 µm.

### <Production of multilayer antireflection film>

Subsequently, the lens substrate on which the hard coat layer is formed was placed in a vacuum vapor deposition apparatus, and a vacuum vapor deposition method was applied over the entire hard coat layer surface to form a multilayer antireflection film in which a total of seven layers "SiO₂ layer/ZrO₂ layer/SiO₂ layer/ZrO₂ layer/SiO₂ layer/ZrO₂ layer/SiO₂ layer" (total thickness: about 400 to 600 nm) were layered. The notation "/" indicates that the portion described on the left and the portion described on the right of "/" are directly layered. The same point applies to the following description.

This process was used to produce a spectacle lens having a layer configuration of "lens substrate/hard coat layer/multilayer antireflection film (inorganic layer; the content of inorganic substance: 90 mass% or more)".

### <Production of metal-containing layer>

### (Preparation of vapor deposition source)

A first metal-containing solution prepared was an aqueous dispersion containing silver particles having a particle size of 2 to 5 nm at a concentration of 5000 ppm.

A second metal-containing solution prepared was an aqueous dispersion containing platinum particles having a particle size of 2 to 5 nm at a concentration of 5000 ppm.

A carrier used was a disk-shaped sintered filter (material: SUS) having a diameter of 18 mm, and after 0.5 ml of the first metal-containing solution was injected into the sintered filter, the sintered filter was subjected to drying treatment in an air oven at an internal temperature of 65 to 75°C for 1 hour. This process was repeated twice (total amount of the first metal-containing solution injected into the carrier: 1.0 ml), and then 0.5 ml of the second metal-containing solution was injected and subjected to drying treatment in an air oven at an internal temperature of 65 to 75°C for 1 hour. This process was repeated twice (total amount of the second metal-containing solution injected into the carrier: 1.0 ml) to prepare a vapor deposition source in which silver particles and platinum particles (vapor deposition materials) were supported on the sintered filter.

### (Film formation of metal-containing layer by electron-beam vapor deposition method)

As shown in Fig. 1, a vacuum chamber of a vacuum vapor deposition apparatus included a spectacle lens having a multilayer antireflection film and a vapor deposition source. The pressure in the vacuum chamber was set to 2 × 10⁻² Pa or less, the electron-beam irradiation conditions were set such that the electron-beam output (heating current) was 38 mA and the electron-beam irradiation time was 150 seconds. Then, an electron-beam was emitted from the electron gun toward the vapor deposition source. By irradiating the silver particles and the platinum particles with the electron-beam in this way, the silver particles and the platinum particles can be heated and vaporized, and a vapor-deposited film in which the silver particles and the platinum particles are accumulated can be formed on the surface of the multilayer antireflection film. In this way, a metal-containing layer (metal-containing inorganic layer containing metals (silver and platinum) and having an inorganic substance content of 90 mass% or more) was deposited on a surface of the multilayer antireflection film.

### <Production of water-repellent layer>

### (Preparation of vapor deposition source)

A solution containing m-xylene hexafluoride as a fluorine-based organic substance was provided.

A carrier used was a disk-shaped sintered filter (material: SUS) having a diameter of 18 mm, and after 0.25 ml of the above-described solution was injected into the sintered filter, the sintered filter was subjected to drying treatment in an air oven at an internal temperature of 50°C for 1 hour.

This procedure was used to prepare a vapor deposition source in which m-xylene hexafluoride (vapor deposition material) was supported on the sintered filter.

### (Film formation of water-repellent layer by heating vapor deposition method)

As shown in Fig. 1, a vacuum chamber of a vacuum vapor deposition apparatus included a spectacle lens having the above metal-containing layer and the vapor deposition source.

The electron gun in Fig. 1 was replaced with a halogen heater, the internal atmosphere temperature in the vacuum chamber was controlled to 650 °C with the halogen heater, the pressure in the vacuum chamber was set to 2 × 10⁻² Pa or less, and a water-repellent layer was deposited by a heating vapor deposition method. In this way, by heating the inside of the chamber, metaxylene hexafluoride can be heated and vaporized, and a vapor-deposited film in which metaxylene hexafluoride is accumulated can be formed on the surface of the metal-containing layer. In this way, a water-repellent layer (water repellent agent: m-xylene hexafluoride) having a film thickness of 10 to 20 nm was deposited on the surface of the metal-containing layer.

The above steps were used to produce a spectacle lens of Example 1 having a layer configuration of "lens substrate/hard coat layer/multilayer antireflection film (inorganic layer)/metal-containing layer/water-repellent layer (fluorine-based organic layer with an organic substance content of 90 mass% or more)".

### [Comparative Example 1]

The same procedure as in Example 1 was repeated, except that the metal-containing layer was not produced, to produce a spectacle lens of Comparative Example 1 having a layer configuration of "lens substrate/hard coat layer/multilayer antireflection film (inorganic layer)/water-repellent layer".

### [Example 2]

The same procedure as in Example 1 was repeated, except that the metal-containing layer was produced using the following procedure, to produce a spectacle lens of Example 2 having a layer configuration of "lens substrate/hard coat layer/multilayer antireflection film (inorganic layer)/metal-containing layer/water-repellent layer".

### <Production of metal-containing layer>

### (Preparation of vapor deposition source)

A first metal-containing solution prepared was an aqueous dispersion containing silver particles having a particle size of 2 to 5 nm at a concentration of 5000 ppm.

A second metal-containing solution prepared was an aqueous dispersion containing platinum particles having a particle size of 2 to 5 nm at a concentration of 5000 ppm.

A carrier used was a disk-shaped sintered filter (material: SUS) having a diameter of 18 mm, and after 0.5 ml of the first metal-containing solution was injected into the sintered filter, the sintered filter was subjected to drying treatment in an air oven at an internal temperature of 65 to 75°C for 1 hour. This process was repeated twice (total amount of the first metal-containing solution injected into the carrier: 1.0 ml), and then 0.5 ml of the second metal-containing solution was injected and subjected to drying treatment in an air oven at an internal temperature of 65 to 75°C for 1 hour. This process was repeated twice (total amount of the second metal-containing solution injected into the carrier: 1.0 ml) to prepare a vapor deposition source in which silver particles and platinum particles (vapor deposition materials) were supported on the sintered filter.

In this way, two vapor deposition sources were prepared.

### (Film formation of metal-containing layer by electron-beam vapor deposition method)

As shown in Fig. 1, a vacuum chamber of a vacuum vapor deposition apparatus included a spectacle lens having the multilayer antireflection film and one of the two vapor deposition sources. The pressure in the vacuum chamber was set to 2 × 10⁻² Pa or less, the electron-beam irradiation conditions were set such that the electron-beam output (heating current) was 38 mA and the electron-beam irradiation time was 150 seconds. Then, an electron-beam was emitted from the electron gun toward the vapor deposition source. Thus, the first electron-beam vapor deposition process was performed.

The remaining one of the two vapor deposition sources was disposed in a vacuum chamber, and the second electron-beam vapor deposition process was performed under the same conditions as the first electron-beam vapor deposition process.

By irradiating the silver particles and the platinum particles with the electron-beam in this way, the silver particles and the platinum particles can be heated and vaporized, and a vapor-deposited film in which the silver particles and the platinum particles are accumulated can be formed on the surface of the multilayer antireflection film.

As described above, by performing the two electron-beam vapor deposition processes, a metal-containing layer (metal-containing inorganic layer containing metals (silver and platinum) and having an inorganic substance content of 90 mass% or more) was deposited on a surface of the multilayer antireflection film.

### [Antimicrobial performance test]

Each spectacle lens of Example 1 or 2 or Comparative Example 1 was subjected to an antimicrobial performance test in accordance with JIS Z 2801:2012.

Specifically, three sample pieces are cut out from each spectacle lens for initial evaluation of antimicrobial performance, evaluation of water resistance, and evaluation of light resistance. The size of each sample piece is 50 mm × 50 mm.

The initial evaluation is performed by the following procedure.

Put a test piece cut out from each spectacle lens in a sterilized petri dish while placing upward the surface on the side where various layers are layered. Then add dropwise 0.4 ml of a microbial suspension containing 1.0 × 10⁵ to 4.0 × 10⁵ test bacteria (Staphylococcus aureus or Escherichia coli) onto the center portion of the surface of the sample, and cover the dish with a polyethylene film cut to a size of 40 mm × 40 mm. Place this petri dish under an environment at a relative humidity of 90% or higher for 24 hours, and then measure the viable cell count per cm².

The water resistance is evaluated using the following procedure.

The test piece cut out from each spectacle lens is subjected to a class 1 water resistance test described in the water resistance test section of the sustainability test method (2018 edition) of SIAA (the Society of International sustaining growth for Antimicrobial Articles). Thereafter, the same treatment as described above is performed, and the viable cell count is then measured.

The light resistance is evaluated using the following procedure.

The test piece cut out from each spectacle lens is subjected to a class 1 light resistance test described in the water resistance test section of the sustainability test method (2018 edition) of SIAA (the Society of International sustaining growth for Antimicrobial Articles). Thereafter, the same treatment as described above is performed, and the viable cell count is then measured.

Table 1 shows the viable cell counts measured in the above various evaluations of Comparative Example 1.

**[Table 1]**

| Table 1: Evaluation results of Comparative Example 1 | | |
|---|---|---|
| Evaluation | | Viable cell count |
| Staphylococcus aureus | Initial evaluation | 1 × 10^{3.95} |
| | Water resistance evaluation | 1 × 10^{4.17} |
| | Light resistance evaluation | 1 × 10^{3.99} |
| Escherichia coli | Initial evaluation | 1 × 10^{5.95} |
| | Water resistance evaluation | 1 × 10^{6.05} |
| | Light resistance evaluation | 1 × 10^{6.04} |

Antimicrobial activity was calculated, using the formula below, from the viable cell counts measured for the above various evaluations in Example 1.

Antimicrobial activity was calculated, using the formula below, from the viable cell counts measured for the above various evaluations in Example 2.$Antimicrobial activity = Ut - At$
Ut: logarithmic value of viable cell count in a sample piece of Comparative Example 1
At: logarithmic value of viable cell count in a sample piece of Example 1 or Example 2

SIAA defines that when the antimicrobial activity is 2.0 or higher, the antimicrobial performance is effective.

Table 2 shows the evaluation results of Example 1, and Table 3 shows the evaluation results of Example 2.

**[Table 2]**

| Table 2: Evaluation results of Example 1 | | |
|---|---|---|
| Evaluation | | Antimicrobial activity |
| Staphylococcus aureus | Initial evaluation | More than 2.0 |
| | Water resistance evaluation | More than 2.0 |
| | Light resistance evaluation | More than 2.0 |
| Escherichia coli | Initial evaluation | More than 2.0 |
| | Water resistance evaluation | More than 2.0 |
| | Light resistance evaluation | More than 2.0 |

**[Table 3]**

| Table 3: Evaluation results of Example 2 | | |
|---|---|---|
| Evaluation | | Antimicrobial activity |
| Staphylococcus aureus | Initial evaluation | More than 2.0 |
| | Water resistance evaluation | More than 2.0 |
| | Light resistance evaluation | More than 2.0 |
| Escherichia coli | Initial evaluation | More than 2.0 |
| | Water resistance evaluation | More than 2.0 |
| | Light resistance evaluation | More than 2.0 |

### [Evaluation of reflection characteristics and transmission characteristics]

Normal incidence reflection spectral characteristics at the optical center of the object-side surface (on the convex surface side) were measured from the object side of each spectacle lens of Example 1 or 2 or Comparative Example 1.

In addition, normal incidence reflection spectral characteristics at the optical center of the eyeball-side surface (on the concave surface side) were measured from the eyeball side of each spectacle lens of Example 1 or 2 or Comparative Example 1.

The spectrum shapes of the transmission spectrum, the reflection spectrum on the convex surface side, and the reflection spectrum on the concave surface side of Example 1 or 2 at a wavelength of 380 to 780 nm as obtained from the measured results were almost the same as the spectrum shapes of each spectrum of Comparative Example 1.

From the measured results, the luminous reflectance was determined according to JIS T 7334:2011, and the luminous transmittance was determined according to JIS T 7333:2005. Table 4 shows the results.

**[Table 4]**

| Table 4: Luminous reflectance and luminous transmittance of the spectacle lens of Example 1 or 2 or Comparative Example 1 | | | |
|---|---|---|---|
| | Luminous | Luminous | Luminous |
| | reflectance (convex surface side) | reflectance (concave surface side) | transmittance |
| Comparative Example 1 | 0.51% | 0.49% | 98.5% |
| Example 1 | 0.50% | 0.47% | 98.5% |
| Example 2 | 0.47% | 0.45% | 98.4% |

The results shown in Table 4 can indicate that in each spectacle lens of Examples 1 or 2, the metal-containing layer hardly affects the reflection characteristics and transmission characteristics of the spectacle lens.

Cross-sectional observation of each of the spectacle lenses of Examples 1 and 2 by SEM confirmed that the film thickness of the metal-containing layer was 3 nm or less (specifically, 1 nm or more and 3 nm or less). The above cross-sectional observation has demonstrated that the metal-containing layer having excellent film thickness uniformity is formed as a continuous layer without any undeposited portion.

Each embodiment disclosed herein is an example in every respect and should not be restrictively understood. The scope of the present invention is defined not by the above description but by the Claims, and intends to include all modifications within the scope of the Claims.

### Industrial Applicability

An aspect of the present invention is useful in the field of producing a spectacle lens and spectacles.

## Claims

1. A spectacle lens comprising, in this order:
(1) a lens substrate,
(2) an inorganic layer,
(3) a metal-containing layer (14) wherein
- a metal contained in the metal-containing layer is silver and platinum,
- the metal is contained in the form or a single metal or a metal alloy, and
- the layer has a film thickness of 1-3 nm, and
(4) a water-repellent layer which is directly layered on the metal-containing layer.

2. The spectacle lens of claim 1, wherein the inorganic layer is a multilayer film of two or more inorganic layers.

3. The spectacle lens of claim 1 or 2, wherein the water-repellent layer is a fluorine-based organic layer.

4. The spectacle lens of any of claims 1-3, wherein the metal-containing layer is a metal-containing inorganic layer.

5. The spectacle lens of any of claims 1-4, wherein the metal-containing layer is a vapor-deposited film of a vapor deposition material, and the vapor deposition material is particles of the metal.

6. Spectacles comprising the spectacle lens of any of claims 1-5.

## Patentansprüche

1. Brillenglas, umfassend in dieser Reihenfolge:
(1) ein Linsensubstrat,
(2) eine anorganische Schicht,
(3) eine metallhaltige Schicht (14), wobei
- ein in der metallhaltigen Schicht enthaltenes Metall Silber und Platin ist,
- das Metall in Form eines einzelnen Metalls oder einer Metalllegierung vorliegt, und
- die Schicht eine Filmdicke von 1-3 nm aufweist, und
(4) eine wasserabweisende Schicht, die direkt auf die metallhaltige Schicht aufgebracht ist.

2. Brillenglas gemäß Anspruch 1, wobei die anorganische Schicht ein Mehrschichtfilm aus zwei oder mehr anorganischen Schichten ist.

3. Brillenglas gemäß Anspruch 1 oder 2, wobei die wasserabweisende Schicht eine organische Schicht auf Fluorbasis ist.

4. Brillenglas gemäß mindestens einem der Ansprüche 1 bis 3, wobei die metallhaltige Schicht eine metallhaltige anorganische Schicht ist.

5. Brillenglas gemäß mindestens einem der Ansprüche 1 bis 4, wobei die metallhaltige Schicht ein durch Gasphasenabscheidung aufgebrachter Film aus einem Gasphasenabscheidungsmaterial ist, und das Gasphasenabscheidungsmaterial aus Partikeln des Metalls besteht.

6. Brille, die das Brillenglas gemäß mindestens einem der Ansprüche 1 bis 5 umfasst.

## Revendications

1. Verre de lunettes comprenant, dans cet ordre :
(1) un substrat de verre de lunettes,
(2) une couche inorganique,
(3) une couche (14) contenant un métal dans lequel,
- un métal contenu dans la couche contenant un métal est l'argent et le platine,
- le métal est contenu sous la forme d'un seul métal ou d'un alliage métallique, et
- la couche présente une épaisseur de film de 1 à 3 nm, et
(4) une couche hydrofuge qui est stratifiée directement sur la couche contenant un métal.

2. Verre de lunettes selon la revendication 1, dans lequel la couche inorganique est un film multicouche constitué de deux couches inorganiques ou plus.

3. Verre de lunettes selon la revendication 1 ou la revendication 2, dans lequel la couche hydrofuge est une couche organique à base de fluor.

4. Verre de lunettes selon l'une quelconque des revendications 1 à 3, dans lequel la couche contenant un métal est une couche inorganique contenant un métal.

5. Verre de lunettes selon l'une quelconque des revendications 1 à 4, dans lequel la couche contenant un métal est un film déposé en phase vapeur d'un matériau de dépôt en phase vapeur, et le matériau de dépôt en phase vapeur est constitué de particules du métal.

6. Lunettes comprenant le verre de lunettes selon l'une quelconque des revendications 1 à 5.
